# EUROPEAN PATENT APPLICATION

(11) **EP 4 148 776 A1**
(43) Date of publication of application: **15.03.2023**
(21) Application number: 22189218.5
(22) Date of filing: 08.08.2022
(51) Int. Cl.: H01L 21/8238, H01L 27/092, H01L 29/06

(54) **SELECTIVE DEPOPULATION OF GATE-ALL-AROUND SEMICONDUCTOR DEVICES**

(30) Priority: 13.09.2021 US 202117473427
(71) Applicant: INTEL Corporation, Santa Clara, CA 95054 (US)
(72) Inventor: HASAN, Mohammad, Aloha, 97006 (US); GHANI, Tahir, Portland, 97229 (US); PATEL, Pratik, Portland, 97229 (US); GULER, Leonard, Hillsboro, 97124 (US); ONG, Clifford, Portland, 97229 (US); HARAN, Mohit, Hillsboro, 97124 (US)
(74) Representative: HGF

(57) **Abstract**

Techniques are provided herein to form semiconductor devices having a different number of semiconductor nanoribbons compared to other semiconductor devices on the same substrate. In one example, two different semiconductor devices of a given memory cell, such as a random access memory (RAM) cell, include a p-channel device and an n-channel device. More specifically, the p-channel device (102) may be a GAA transistor with a first number of semiconductor nanoribbons (112a) while the n-channel device (104) may be a GAA transistor with a second number of semiconductor nanoribbons (112b) that is greater than the first number of semiconductor nanoribbons. In some cases, the n-channel device(s) have one additional semiconductor nanoribbon compared to the p-channel device(s). Depending on when the nanoribbons are removed during the fabrication process, different structural outcomes will occur that can be detected in the final device.

## Description

### FIELD OF THE DISCLOSURE

The present disclosure relates to integrated circuits, and more particularly, to gate-all-around (GAA) semiconductor devices.

### BACKGROUND

As integrated circuits continue to scale downward in size, a number of challenges arise. For instance, reducing the size of memory and logic cells is becoming increasingly more difficult. Energy consumption of so many semiconductor devices on a given substrate becomes an increasing concern. Some processor cores employ voltage scaling techniques to decrease the energy consumption, however this makes the various semiconductor devices more susceptible to process and/or dopant variations that can cause the devices to not function properly. Accordingly, there remain a number of non-trivial challenges with respect to designing semiconductor devices that can function at lower voltage levels.

### BRIEF DESCRIPTION OF THE DRAWINGS

Figures 1A and 1B are cross-sectional views that illustrate an example integrated circuit having semiconductor devices with a different number of semiconductor nanoribbons, in accordance with an embodiment of the present disclosure.
Figures 2A - 2F are cross-sectional views that collectively illustrate an example process for forming semiconductor devices with a different number of semiconductor nanoribbons, in accordance with an embodiment of the present disclosure.
Figures 3A and 3B are additional cross-sectional views that are orthogonal to the cross-sectional views of Figures 2A - 2F, and that illustrate the semiconductor devices with a different number of semiconductor nanoribbons, in accordance with an embodiment of the present disclosure.
Figure 4A - 4D are cross-sectional views that collectively illustrate another example process for forming semiconductor devices with a different number of semiconductor nanoribbons, in accordance with an embodiment of the present disclosure.
Figures 5A - 5D are cross-sectional views that collectively illustrate another example process for forming semiconductor devices with a different number of semiconductor nanoribbons, in accordance with an embodiment of the present disclosure.
Figure 6 illustrates a cross-section view of a chip package containing one or more semiconductor dies, in accordance with some embodiments of the present disclosure.
Figure 7 is a flowchart of a first fabrication process for semiconductor devices with a different number of semiconductor nanoribbons, in accordance with an embodiment of the present disclosure.
Figure 8 is a flowchart of a second fabrication process for semiconductor devices with a different number of semiconductor nanoribbons, in accordance with an embodiment of the present disclosure.
Figure 9 is a flowchart of a third fabrication process for semiconductor devices with a different number of semiconductor nanoribbons, in accordance with an embodiment of the present disclosure.
Figure 10 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles, and some features may have surface topology or otherwise be non-smooth, given real world limitations of the processing equipment and techniques used.

### DETAILED DESCRIPTION

Techniques are provided herein to form semiconductor devices having a different number of semiconductor nanoribbons (or other semiconductor bodies) compared to other semiconductor devices on the same substrate. The techniques can be used in any number of integrated circuit applications and are particularly useful with respect to logic and memory cells, such as those cells that use gate-all-around (GAA) transistors. In one example, two different semiconductor devices of a given memory cell, such as a synchronous random access memory (SRAM) cell, include a p-channel device and an n-channel device. More specifically, the p-channel device may be a GAA transistor with a first number of semiconductor nanoribbons while the n-channel device may be a GAA transistor with a second number of semiconductor nanoribbons that is greater than the first number of semiconductor nanoribbons. In some cases, the n-channel device(s) have one additional semiconductor nanoribbon compared to the p-channel device(s). According to an embodiment, the p-channel devices are made to include a fewer number of semiconductor nanoribbons in order to structurally lower the operating current through the p-channel devices by decreasing the number of active semiconductor channels. Depending on when the nanoribbons are removed during the fabrication process, different structural outcomes will occur that can be detected in the final device. Numerous variations and embodiments will be apparent in light of this disclosure.

### General Overview

As previously noted above, there remain a number of non-trivial challenges with respect to designing semiconductor devices that consume less energy. As operating voltages decrease, the successful operation of the semiconductor devices of an integrated circuit becomes more susceptible to systemic process variations and/or random dopant fluctuations. In the example of a memory cell, such random dopant and/or process variations could result, for instance, in a p-channel device with a higher drive current than the corresponding n-channel device (strong p-type device and weak n-type device), which can lead to memory write errors. In particular, such a memory cell cannot be written to below some minimum voltage (write failure below Vmin). Some techniques have been implemented to mitigate write failures, but they incur additional power consumption and take up valuable chip footprint, and are relatively difficult to design for (layout).

Thus, and in accordance with an embodiment of the present disclosure, techniques are provided herein to form p-channel devices that are structurally weaker (e.g., lower drive current) compared to n-channel devices on the same substrate. In some embodiments, the number of semiconductor nanoribbons are selectively reduced for the p-channel devices compared to the n-channel devices to weaken the p-channel devices. This reduction can be thought of as a depopulation of active channel pathways. Thus, the nanoribbon depopulation techniques provide a structural solution to reducing potential write errors in memory cells. Although many transistor designs may benefit from these techniques, they are especially useful for GAA structures which have a given number of individual semiconductor channel pathways in the form of nanoribbons to be individually removed. In some embodiments, one or more first (p-type) semiconductor devices each have exactly one fewer semiconductor nanoribbons than a number of nanoribbons found in each of one or more second (n-type) semiconductor devices on the same substrate. There many be any number of nanoribbons missing from a given semiconductor device compared to another semiconductor device on the same substrate. In some embodiments, nanoribbons may be removed from one or more first semiconductor devices such that a first height between a bottommost nanoribbon and a topmost nanoribbon of the one or more first semiconductor devices is less than a second height between a bottommost nanoribbon and a topmost nanoribbon of one or more second semiconductor devices. Note the techniques can be applied to other channel configurations as well, such as nanowires or other GAA configurations that allow for selective depopulation of channel pathways.

Depending on when the nanoribbons are removed during the fabrication process, different structural outcomes will occur. In one example, semiconductor material in a multilayer fin is depopulated or otherwise removed before the source or drain regions have been formed. This yields an integrated circuit with different semiconductor devices having source or drain regions with different heights. In another example, semiconductor material in a multilayer fin is depopulated or otherwise removed after the removal of a sacrificial gate over the multilayer fin, but before any sacrificial material layers have been removed from the multilayer fin. This yields dummy nanoribbon portions within spacer structures adjacent to some of the semiconductor devices and source or drain regions that extend higher over some semiconductor devices compared to others. In another example, one or more semiconductor nanoribbons are depopulated or otherwise removed after the formation of a gate dielectric around the nanoribbons, but before the formation of a gate electrode. This yields dummy nanoribbon portions within spacer structures adjacent to some of the semiconductor devices, source or drain regions that extend higher over some semiconductor devices compared to others, and some semiconductor devices with a dummy gate dielectric layer suspended above the semiconductor nanoribbons. In any such cases, note that depopulated layers of the multilayer fin are not to confused with sacrificial layers of the multilayer fin. In particular, a depopulated layer would be a nanowire but for the depopulation, whereas a sacrificial layer is removed to release a nanowire.

According to an embodiment, an integrated circuit includes a first semiconductor device having a first set of two of more semiconductor bodies extending between a first source region and a first drain region, and a second semiconductor device having a second set of one or more semiconductor bodies extending between a second source region and a second drain region. The second set of semiconductor bodies has a fewer number of bodies than the first set of semiconductor bodies. The first and second semiconductor bodies can be, for example, nanoribbons, nanowires, or other such bodies that can be depopulated using the techniques provided herein. The first semiconductor device has a first gate structure at least partially wrapped around the first set of two or more semiconductor bodies and the second semiconductor device has a second gate structure at least partially wrapped around the second set of one or more semiconductor bodies. Note the gate structures may be gate-all-around structures or tri-gate structures or double-gate structures, depending on the channel configuration.

According to another embodiment, a method of forming an integrated circuit includes forming a first multilayer fin and a second multilayer fin, each of the first and second multilayer fins comprising first and second material layers, wherein the first material layers comprise a sacrificial material to be removed to release at least one of the second material layers, and the second material layers comprise a semiconductor material suitable for use as a channel; forming a dielectric layer between the first multilayer fin and the second multilayer fin; masking the second multilayer fin while leaving the first multilayer fin exposed; and removing at least a topmost second material layer from the first multilayer fin. Subsequent processing may include, for example, the selective etching of sacrificial layers (e.g., silicon germanium layers) included in the fins, so as to release one or more nanoribbons (e.g., silicon) or other gate-all-around channel regions.

According to another embodiment, a method of forming an integrated circuit includes forming a first multilayer fin and a second multilayer fin, each of the first and second multilayer fins comprising first and second material layers, wherein the first material layers comprise a sacrificial material to be removed to release at least one of the second material layers, and the second material layers comprise a semiconductor material suitable for use as a channel; forming a first sacrificial gate over the first multilayer fin and a second sacrificial gate over the second multilayer fin; forming a first gate spacer on sidewalls of the first sacrificial gate and a second gate spacer on sidewalls of the second sacrificial gate; removing the second sacrificial gate; and removing at least a topmost second material layer of the first multilayer fin while protecting a topmost second material layer of the second multilayer fin. Subsequent processing may include, for example, the selective etching of sacrificial layers (e.g., silicon germanium layers) included in the fins, so as to release one or more nanoribbons (e.g., silicon) or other gate-all-around channel regions.

The techniques are especially suited for use with gate-all-around transistors such as nanowire and nanoribbon transistors, but may also be applicable in some instances to finFET devices (e.g., reducing the height of some finFET devices compared to other finFET devices on the same substrate). The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate electrode can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate p-type semiconductor devices having a different number of nanoribbons compared to n-type semiconductor devices. In some embodiments, such tools may indicate some semiconductor devices having dummy nanoribbon structures present within the spacer structures. In some embodiments, such tools may indicate adjacent semiconductor devices that share a source or drain region, where the source or drain region has a first height above the semiconductor nanoribbons of one semiconductor device and a different second height above the semiconductor nanoribbons of the other semiconductor device. In some embodiments, such tools may indicate the presence of dummy gate dielectric layers suspended above the semiconductor nanoribbons of some of the semiconductor devices.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer.

### Architecture

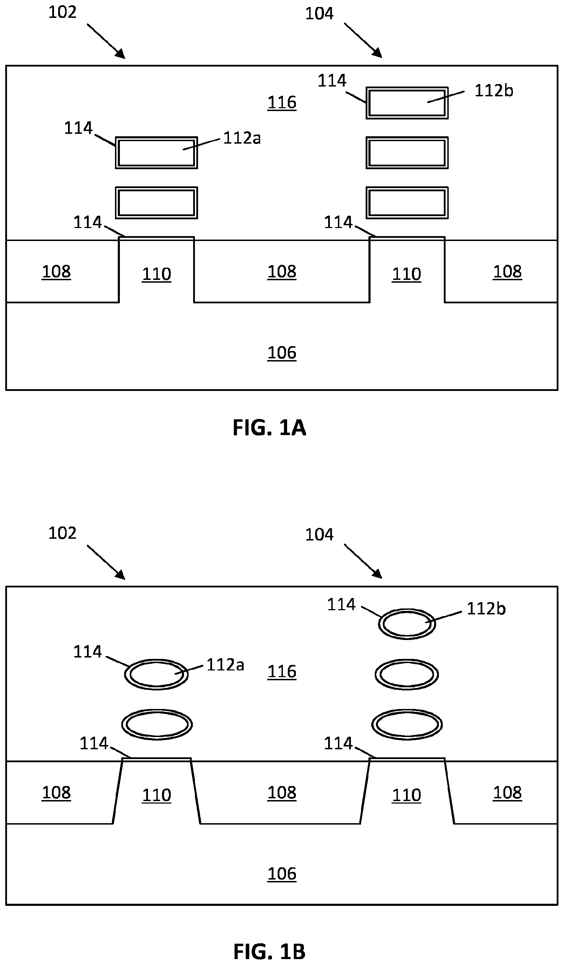

Figure 1A is a cross sectional view taken across two example semiconductor devices 102 and 104, according to an embodiment of the present disclosure. Each of semiconductor devices 102 and 104 may be non-planar metal oxide semiconductor (MOS) transistors, such as tri-gate or gate-all-around (GAA) transistors, although other transistor topologies and types could also benefit from the techniques provided herein. The illustrated embodiments herein use the GAA structure. Semiconductor devices 102 and 104 represent a portion of an integrated circuit that may contain any number of similar semiconductor devices.

As can be seen, semiconductor devices 102 and 104 are formed on a substrate 106. Any number of semiconductor devices can be formed on substrate 106, but two are used here as an example. Substrate 106 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used.

The semiconductor material in each of semiconductor devices 102 and 104 may be formed from substrate 106. Semiconductor devices 102 and 104 may each include semiconductor material as nanowires or nanoribbons that can be, for example, native to substrate 106 (formed from the substrate itself). Alternatively, the semiconductor material can be formed of material deposited onto an underlying substrate. In one such example case, a blanket layer of silicon germanium (SiGe) can be deposited onto a silicon substrate, and then patterned and etched to form a plurality of SiGe fins or nanoribbons. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out.

As can further be seen, adjacent semiconductor devices are separated by a dielectric fill 108 that may include silicon oxide. Dielectric fill 108 provides shallow trench isolation (STI) between any adjacent semiconductor devices. Dielectric fill 108 can be any suitable dielectric material, such as silicon dioxide, aluminum oxide, or silicon oxycarbonitride.

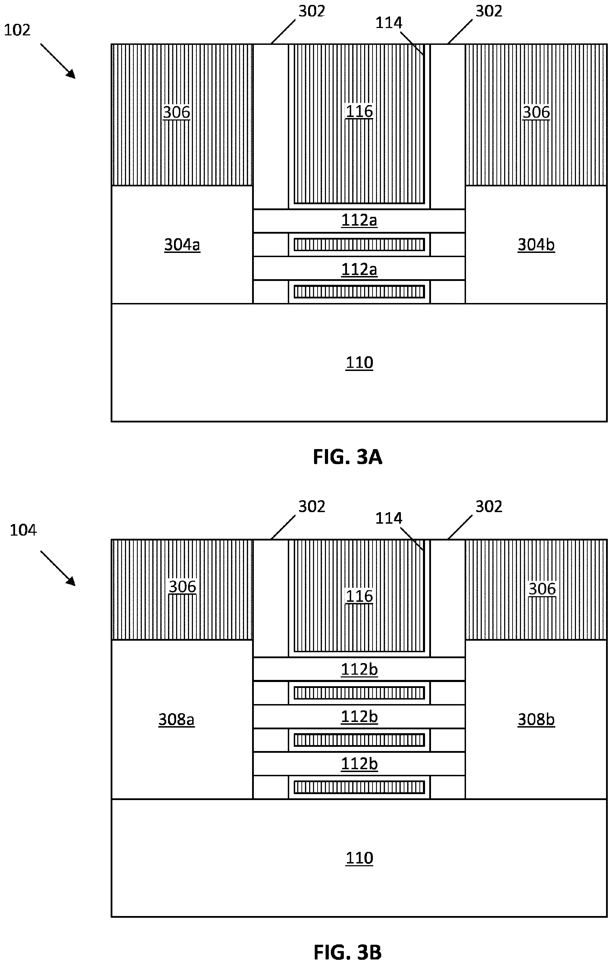

Semiconductor device 102 includes a subfin region 110 and a plurality of nanoribbons 112a above the subfin region 110 (semiconductor device 104 similarly includes nanoribbons 112b above subfin region 110). According to some embodiments, subfin region 110 comprises the same semiconductor material as substrate 106 and is adjacent to dielectric fill 108. According to some embodiments, nanoribbons 112a and 112b extend between a corresponding source and a drain region to provide an active region for a transistor (e.g., the semiconductor region beneath the gate). The source and drain regions are not shown in the cross-section of Figure 1A, but are shown in the orthogonal cross-sections through semiconductor devices 102 and 104 illustrated in Figures 3A and 3B.

According to some embodiments, the source and drain regions are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used.

Nanoribbons 112a and 112b include a gate dielectric 114 that may include a single material layer or multiple stacked material layers. In some embodiments, gate dielectric 114 includes a first dielectric layer such as silicon oxide and a second dielectric layer that includes a high-K material such as hafnium oxide. The hafnium oxide may be doped with an element to affect the threshold voltage of the given semiconductor device. In some embodiments, the gate dielectric 114 around semiconductor device 102 has a different element doping concentration compared to the gate dielectric 114 around semiconductor device 104. According to some embodiments, the doping element used in gate dielectric 114 is lanthanum. Gate dielectric 114 is present around each nanoribbon 112a and 112b and may also be present over subfin portion 110. In some embodiments, gate dielectric 114 is also present over the top surface of dielectric fill 108.

According to some embodiments, a gate electrode 116 extends over the nanoribbons 112a and 112b of semiconductor devices 102 and 104, respectively. Gate electrode 116 may include any sufficiently conductive material such as a metal, metal alloy, or doped polysilicon. According to some embodiments, gate electrode 116 may be interrupted between any adjacent semiconductor devices by a gate cut structure. In some embodiments, one or more work function metals may be included around nanoribbons 112a and 112b. In some embodiments, semiconductor device 102 is a p-channel device that includes a work function metal having titanium and semiconductor device 104 is an n-channel device that includes a work function metal having tungsten. The combination of gate dielectric 114 and gate electrode 116 forms a gate structure for each of semiconductor device 102 and semiconductor device 104.

As discussed above, semiconductor device 102 may be a p-channel device having semiconductor nanoribbons 112a doped with n-type dopants (e.g., phosphorous or arsenic) and semiconductor device 104 may be an n-channel device having semiconductor nanoribbons 112b doped with p-type dopants (e.g., boron). There are fewer nanoribbons 112a in semiconductor device 102 compared to semiconductor device 104, according to some embodiments. In one example, there is exactly one fewer nanoribbon 112a in semiconductor device 102 compared to semiconductor device 104. Various methods may be used to selectively remove one or more nanoribbons from semiconductor device 102 as compared to semiconductor device 104, as will be discussed in more detail herein. In some embodiments, one or more nanoribbons may be removed from any number of p-channel devices in an integrated circuit. Furthermore, different numbers of nanoribbons can be removed from different devices by repeating many of the processes described herein. For example, only a single nanoribbon may be removed from a first set of p-channel devices while two or more nanoribbons may be removed from a second set of p-channel devices in the same integrated circuit.

Figure 1B illustrates an integrated circuit similar to that depicted in Figure 1A, except that the various features are drawn to reflect real-world process conditions, according to an embodiment. For instance, while Figure 1A generally indicates the various features using straight lines, right angles, and smooth surfaces, an actual integrated circuit structure configured in accordance with an embodiment of the present disclosure may have less than perfect straight lines and right angles, and some features may have a rough surface topography or otherwise be non-smooth, given real-world limitations of fabrication processes such as etching and depositing. As can be seen in Figure 1B, subfins 110 may be tapered rather than rectangular, and nanoribbons 112a/112b are more rounded and blob-like. Note that the nanoribbons may taper as well, such that the uppermost nanoribbon is less wide than the lowermost nanoribbon, and the middle nanoribbon has a width that is between the width of the lowermost nanoribbon and the width of the uppermost nanoribbon. Further note that sidewalls of the subfins 110 may be collinear with the sidewalls of the corresponding nanoribbons 112a and 112b.

### Fabrication Methodology

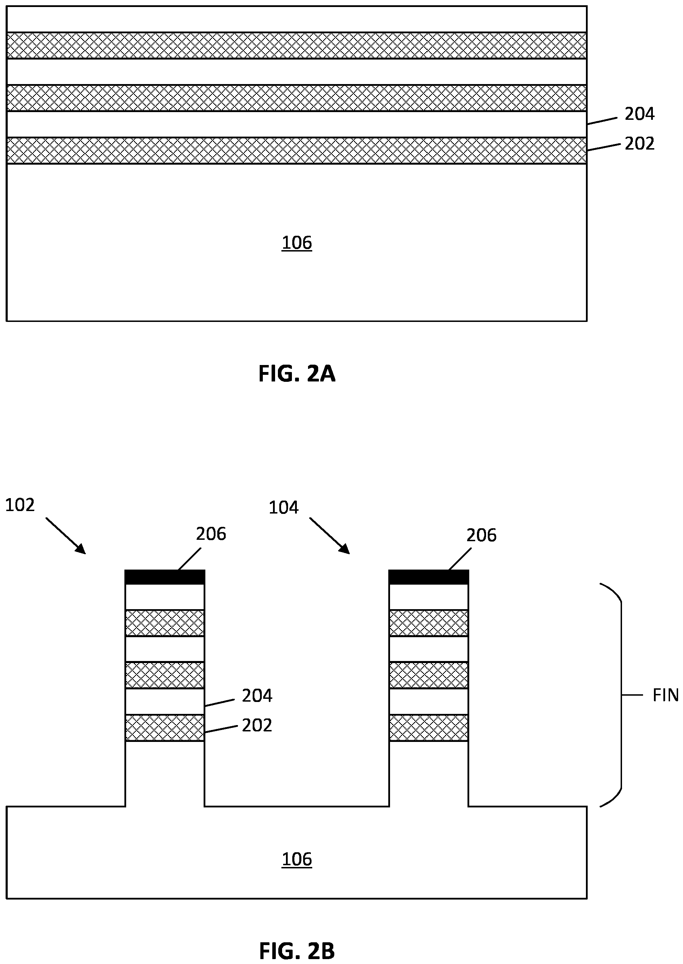

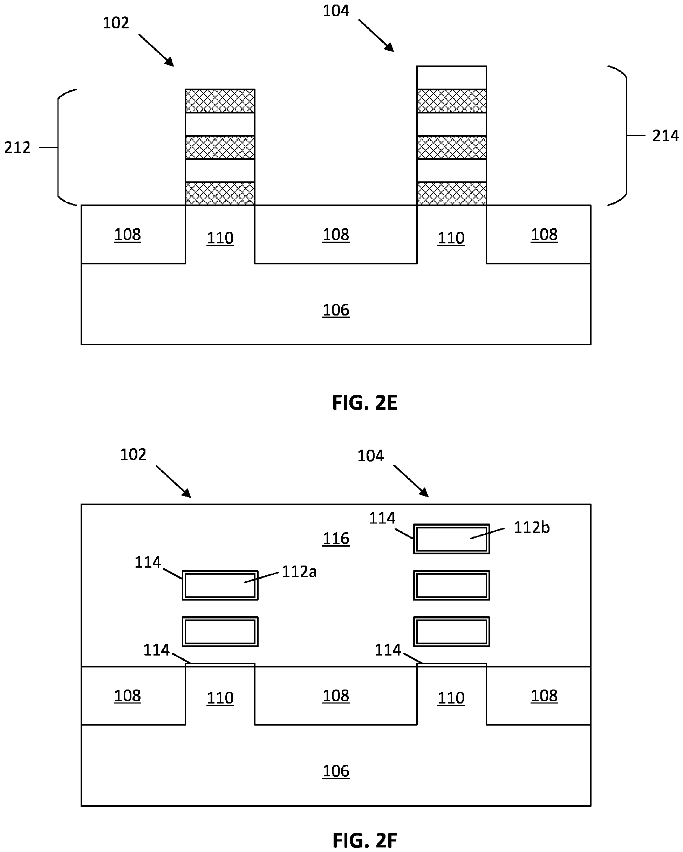

Figures 2A - 2F include cross-sectional views that collectively illustrate an example process for forming an integrated circuit configured with semiconductor devices having a different number of nanoribbons compared to other semiconductor devices on the same substrate, in accordance with an embodiment of the present disclosure. Each figure shows an example structure that results from the process flow up to that point in time, so the depicted structure evolves as the process flow continues, culminating in the structure shown in Figure 2F, which is similar to the structure illustrated in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view across a substrate having a series of material layers deposited over it, according to an embodiment of the present disclosure. The previous relevant discussion with respect to example configurations and materials for substrate 106 is equally applicable here. Alternating material layers may be deposited over substrate 106 that include sacrificial layers 202 alternating with semiconductor layers 204. Any number of alternating sacrificial layers 202 and semiconductor layers 204 may be deposited. Semiconductor layers 204 may include silicon, germanium, or a combination thereof. Sacrificial layers 202 have a different material composition than semiconductor layers 204. In some embodiments, sacrificial layers 202 include some combination of silicon and germanium. In other embodiments, sacrificial layers 202 include a higher germanium content compared to semiconductor layers 204. While dimensions can vary from one example embodiment to the next, the thickness of each semiconductor layer 204 and sacrificial layer 202 may be between about 5 nm and about 25 nm. Each of sacrificial layer 202 and semiconductor layer 204 may be deposited using any known material deposition technique, such as chemical vapor deposition (CVD), plasma-enhanced chemical vapor deposition (PECVD), physical vapor deposition (PVD), or atomic layer deposition (ALD).

Figure 2B illustrates a cross-sectional view of the structure shown in Figure 2A following the formation of semiconductor fins, according to an embodiment of the present disclosure. Any number of fins can be patterned across the integrated circuit, but only two are illustrated here for clarity. Each of semiconductor device 102 and 104 includes a semiconductor fin. The fins can include at least a portion that is native to the substrate, as illustrated, or may be non-native to the substrate. Each of the illustrated fins includes a multilayer structure having alternating sacrificial layers 202 and semiconductor layers 204. In some embodiments, the fins are alternating with respect to transistor polarity. For instance, the fin of semiconductor device 102 can include a PMOS material fin (e.g., semiconductor layers 204 are doped with n-type dopants) and the fin of semiconductor device 104 can include an NMOS material fin (e.g., semiconductor layers 204 are doped with p-type dopants) for a first logic or memory cell. Numerous other configurations can be used, including fins included in integrated circuit sections other than memory or logic sections, such as analog mixed signal sections, input/output sections, radio frequency or transducer sections.

The fins may be formed by using a patterned hard mask layer or photoresist such as a cap layer 206. According to some embodiments, cap layer 206 protects the underlying material during a directional etching process, such as reactive ion etching (RIE). Cap layer may be, for example, a nitride, oxynitride, a carbide, or an oxycarbonitride. While dimensions can vary from one example embodiment to the next, the total height of the fins extending above the surface of substrate 106 may be in the range of about 100 nm to about 250 nm.

It should be noted that the fin fabrication process described with reference to Figures 2A and 2B is just one example process for forming multilayer fins. Other processes may be used as well, such as the aforementioned aspect ratio trapping based process.

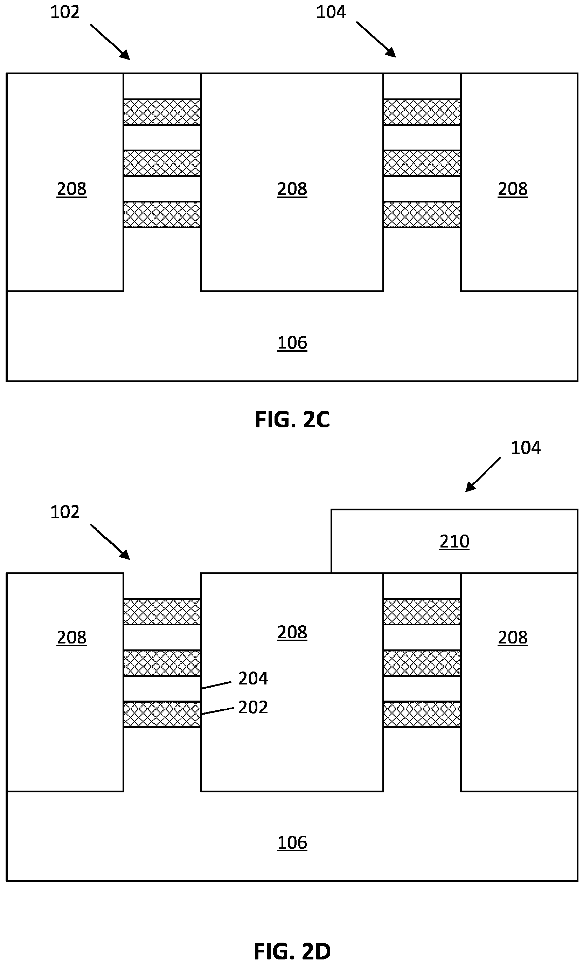

Figure 2C illustrates a cross-sectional view of the structure shown in Figure 2B following the formation of a dielectric fill 208, according to an embodiment of the present disclosure. In some embodiments, dielectric fill 208 includes silicon oxide, although other oxides or dielectrics may be used as well. Dielectric fill 208 may be deposited using any known dielectric material deposition technique, such as CVD, PECVD, flowable CVD, spin-on dielectric, or ALD, to name a few examples. Dielectric fill 208 may first be deposited to at least fill the regions between adjacent fins, and then polished back until it is level with a top surface of the fins, as illustrated. The polishing process may be performed using chemical mechanical polishing (CMP).

Figure 2D illustrates a cross-sectional view of the structure shown in Figure 2C following the selective removal of one or more semiconductor layers 204, according to an embodiment of the present disclosure. A masking material 210 is deposited and patterned to cover one or more of the fins, such as the fin of semiconductor device 104. In some embodiments, masking material 210 is patterned to cover one or more n-channel semiconductor devices while exposing one or more of the p-channel semiconductor devices. Masking material 210 may be a photoresist or hard mask material, such as a carbon hard mask.

The top one or more material layers of the exposed fins (such as the exposed fin of semiconductor device 102) may be removed using an isotropic or anisotropic etch process (such as a plasma-based etching process). In one example, reactive ion etching (RIE) is used to remove any number of material layers from the fin of semiconductor device 102. The removed material layers may include both semiconductor layers 204 and sacrificial layers 202, or just a top-most semiconductor layer 204, as illustrated. Each semiconductor layer 204 that is removed ultimately removes one nanoribbon from the resulting transistor of semiconductor device 102.

Figure 2E illustrates a cross-sectional view of the structure shown in Figure 2D following the formation of dielectric fill 108, according to an embodiment of the present disclosure. Dielectric fill 108 may act as shallow trench isolation (STI) between adjacent semiconductor devices. In some embodiments, dielectric fill 108 is formed by recessing dielectric fill 208 using any known isotropic etching process. In some embodiments, dielectric fill 208 is completely removed, followed by the deposition of dielectric fill 108 to at least the same height as the fins, and then recessed back using any known controlled etching process to the final height shown. According to some embodiments, each of the fins includes a subfin portion 110 beneath an exposed fin 212 of semiconductor device 102 and an exposed fin 214 of semiconductor device 104 and between dielectric fill 108. Subfin portion 110 may include the same material as semiconductor substrate 106 and may be an integral part of semiconductor substrate 106 that would extend below dielectric fill 108. Following the formation of dielectric fill 108, the exposed fin 214 (e.g., with no removed layers) extending above a top surface of dielectric layer 108 may have a height between about 50 nm and about 200 nm. The width of the fins can be, for example, in the range of about 5 to about 15 nm, such as 6 nm wide. Exposed fin 212 will have a shorter height than exposed fin 214 since one or more layers of exposed fin 212 have been removed. The height of exposed fin 212 extending above a top surface of dielectric layer 108 will depend on the number of material layers that were removed, but in some examples is between about 30 nm and about 140 nm.

At this stage, subsequent processes are performed to form the remaining GAA transistor structures that ultimately yield the structure illustrated in Figure 2F. Briefly, these remaining processes involve the formation of source and drain regions for each of semiconductor devices 102 and 104, the removal of sacrificial layers 202 to form suspended nanoribbons 112a/112b, the formation of gate dielectric 114 around the nanoribbons 112a/112b, and the formation of gate electrode 116. The results of many of these processes cannot be seen in the illustrated cross-section and so are shown in Figures 3A and 3B, which illustrate orthogonal cross-section views through semiconductor device 102 and 104, respectively, according to some embodiments. Since the nanoribbons of both semiconductor devices 102 and 104 were formed by removing similar sacrificial layers, the spacing between adjacent nanoribbons 112a is substantially the same as a spacing between adjacent nanoribbons 112b (e.g., within 1 nm).

Figure 3A illustrates spacer structures 302 on either side of gate electrode 116 as would be understood to a person skilled in the relevant art. Spacer structures 302 may include a dielectric material, such as silicon nitride. Each of suspended nanoribbons 112a extends between source or drain regions 304a and 304b. As noted above, source or drain regions 304a and 304b can be epitaxial regions that are provided using an etch-and-replace process, and doped with n-type or p-type dopants depending on the channel type of the transistor. Any semiconductor materials suitable for source and drain regions can be used (e.g., group IV and group III-V semiconductor materials). In some embodiments, conductive contacts 306 are formed over source or drain regions 304a and 304b. Conductive contacts 306 may be any suitably conductive material such as most metals. In some embodiments, conductive contacts 306 include one or more of the same metal materials as gate electrode 116.

Figure 3B illustrates many of the same structures for semiconductor device 104 as described above for semiconductor device 102. According to some embodiments, the source or drain regions 308a and 308b of semiconductor device 104 are taller compared to the source or drain regions 304a and 304b of semiconductor device 102. This may occur due to the fact that the number of semiconductor nanoribbons in semiconductor device 102 was reduced before the formation of source or drain regions 304a and 304b (e.g., the source and drain regions are grown to a sufficient height to contact each of the nanoribbons).

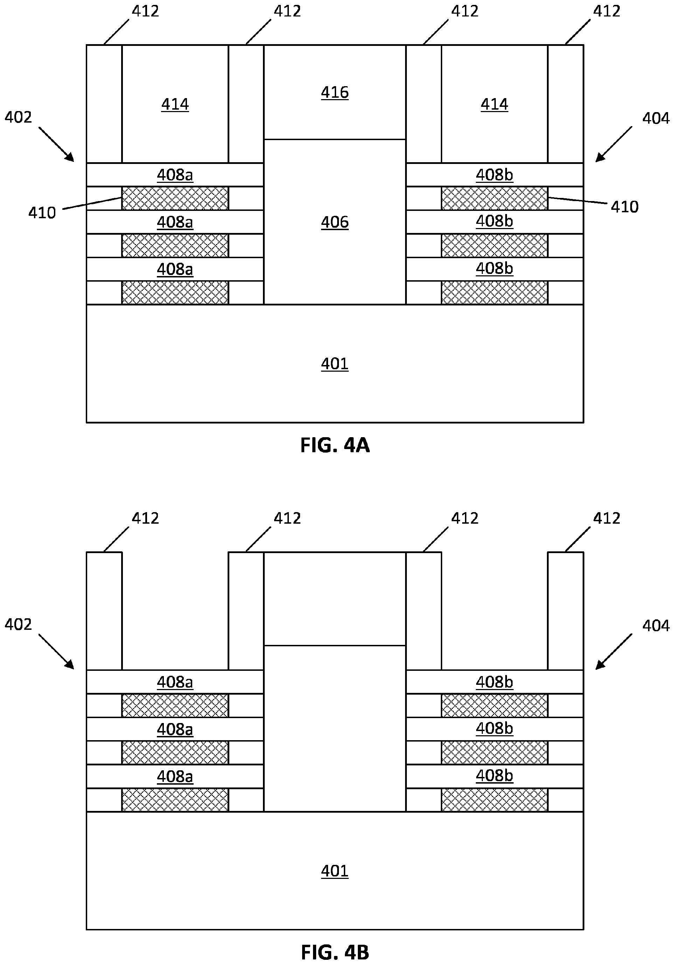

Figures 4A - 4D include cross-sectional views that collectively illustrate another example process for forming an integrated circuit configured with semiconductor devices having a different number of nanoribbons compared to other semiconductor devices on the same substrate, in accordance with an embodiment of the present disclosure. In general, as compared to the process illustrated in Figures 2A - 2F, this procedure takes place after the source or drain regions have been formed. Each figure shows an example structure that results from the process flow up to that point in time, so the depicted structure evolves as the process flow continues. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 4A illustrates a cross-sectional view across a substrate 401 having two adjacent semiconductor devices 402 and 404. Substrate 401 may be similar to substrate 106 as described above. Semiconductor devices 402 and 404 may be GAA structures that share a common source or drain region 406. Semiconductor device 402 includes semiconductor nanoribbons 408a while semiconductor device 404 includes semiconductor nanoribbons 408b. Semiconductor nanoribbons 408a and 408b alternate with sacrificial layers 410 between spacer structures 412. Semiconductor nanoribbons 408a and 408b may be similar to semiconductor layers 204 while sacrificial layers 410 may be similar to sacrificial layers 202, as discussed above.

A sacrificial gate layer 414 may be present over both semiconductor devices 102 and 104 and within spacer structures 412. According to some embodiments, sacrificial gate layer 414 may include any material that can be safely removed without etching or otherwise damaging any portions of semiconductor nanoribbons 408a/408b and spacer structures 412. In some embodiments, sacrificial gate layer 414 comprises polysilicon. In some embodiments, a conductive contact 416 is formed over source or drain region 406 and may be similar to conductive contacts 306 described above.

Figure 4B illustrates a cross-sectional view of the structure shown in Figure 4A following the removal of sacrificial gate layer 414, according to an embodiment of the present disclosure. Sacrificial gate layer 414 may be removed using any wet or dry isotropic process thus exposing the portions of the fins between spacer structures 412. In other words, the alternating layer stack of each of the fins is exposed within the trench between spacer structures 412 that is left behind after the removal of sacrificial gate layer 414.

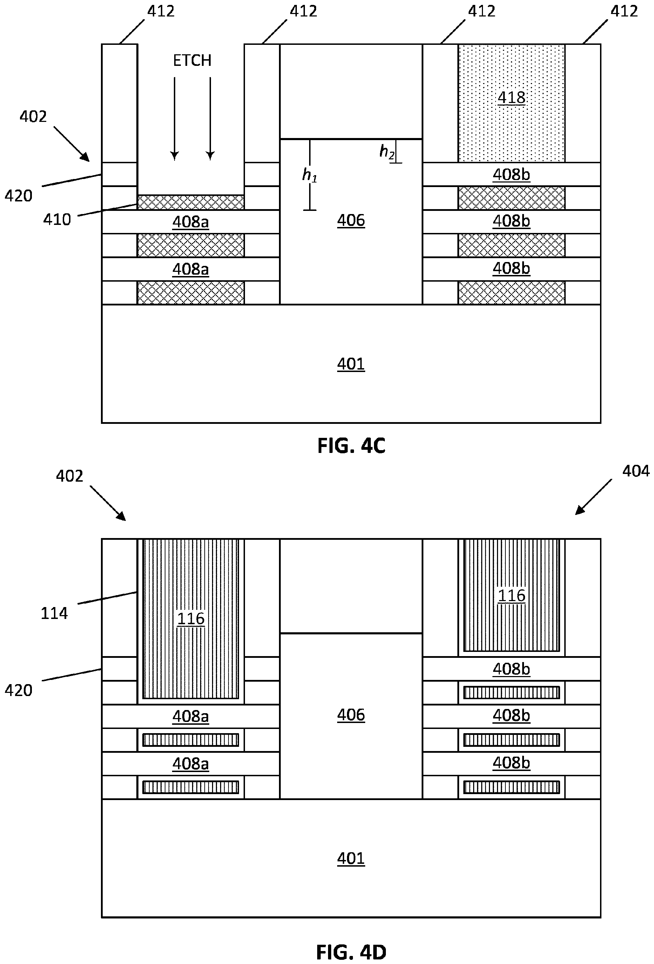

Figure 4C illustrates a cross-sectional view of the structure shown in Figure 4B following the selective removal of one or more nanoribbons, according to an embodiment of the present disclosure. A masking material 418 is deposited and patterned to cover one or more of the fins, such as the fin of semiconductor device 404 within the region between spacer structures 412. In some embodiments, masking material 418 is patterned to cover one or more n-channel semiconductor devices while exposing one or more of the p-channel semiconductor devices. Masking material 418 may be a photoresist or hard mask material, such as a carbon hard mask.

The top one or more material layers of the exposed fins (such as the exposed fin of semiconductor device 402) may be removed using an anisotropic etch process (such as a plasma-based etching process). In one example, RIE is used to remove any number of material layers from the fin of semiconductor device 402 starting with the top layer and moving downwards. The removed material layers may include both nanoribbons 408a and sacrificial layers 410. According to some embodiments, any portion of a sacrificial layer 410 may be removed following the removal of the above nanoribbon 408a. In the illustrated embodiment, only a top nanoribbon 408a has been removed from the fin of semiconductor device 402.

Since the etching process used to remove one or more nanoribbons is performed after the formation of source or drain region 406, source or drain region 406 will extend above a top-most nanoribbon 408a of semiconductor device 402 at a first height *h₁* and extend above a top-most nanoribbon 408b of semiconductor device 404 at a second height *h₂* that is less than the first height *h₁*. The height difference will depend on the number of nanoribbons removed from semiconductor device 402. In some examples, height *h₁* may be between about 1 nm and about 5 nm and height *h₂* may be between about 10 nm and about 50 nm. Additionally, due to the timing of the etch process used to remove one or more nanoribbons, one or more dummy channel structures 420 are present within spacer structures 412. According to some embodiments, dummy channel structures 420 are aligned with the removed nanoribbons. In some embodiments, dummy channel structures 420 are aligned on the same plane as other nanoribbons 408b from semiconductor devices that did not have nanoribbons removed from that plane (such as semiconductor device 404). Dummy channel structures 420 may be formed as a pair with one dummy channel structure within one spacer structure 412 and the other dummy channel structure within the other spacer structure 412 of a given semiconductor device. It should be understood that only one source or drain region 406 has been illustrated, but that further source or drain regions would be present on the opposite sides of nanoribbons 408a and nanoribbons 408b and these further source or drain regions would have substantially the same height as source or drain region 406.

Figure 4D illustrates a cross-sectional view of the structure shown in Figure 4C following the formation of the remaining transistor structures, according to an embodiment of the present disclosure. Following the removal of masking material 418 and sacrificial layers 410 from both semiconductor devices 402 and 404, gate dielectric layer 414 is formed over the suspended nanoribbons, followed by the formation of gate electrode 116 over semiconductor nanoribbons 408a and 408b. Note that the dummy channel structures 420 remain in the final structure with one extending between source or drain region 406 and gate electrode 116 and the other extending between another source or drain region (not shown) and gate electrode 116.

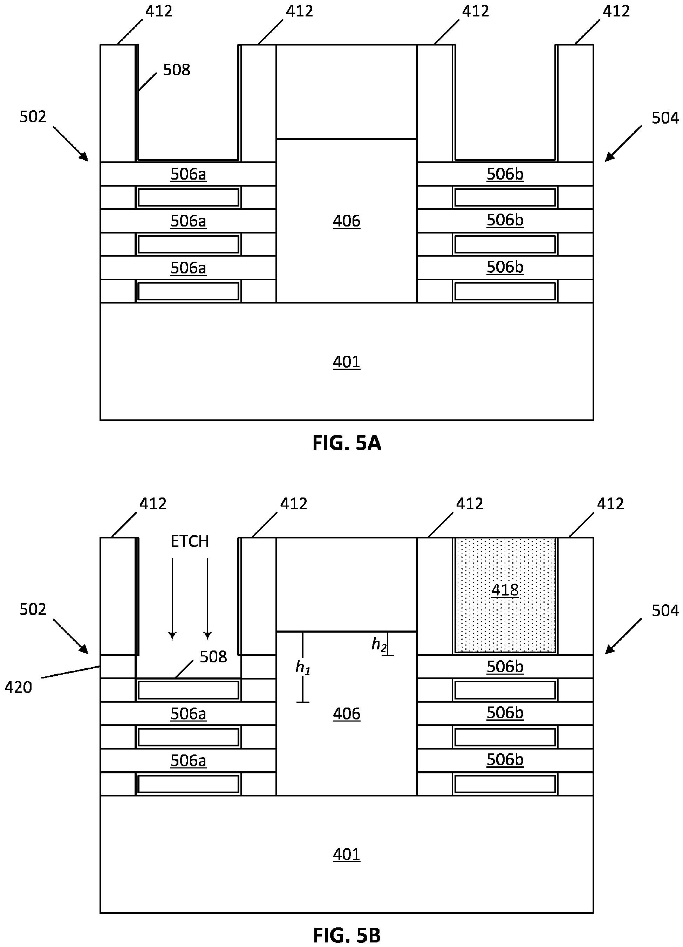

Figures 5A - 5E include cross-sectional views that collectively illustrate another example process for forming an integrated circuit configured with semiconductor devices having a different number of nanoribbons compared to other semiconductor devices on the same substrate, in accordance with an embodiment of the present disclosure. In general, as compared to the process illustrated in Figures 2A- 2F, this procedure takes place after the gate dielectric layer has been formed over the suspended nanoribbons (e.g., just before the formation of the gate electrode). Each figure shows an example structure that results from the process flow up to that point in time, so the depicted structure evolves as the process flow continues. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 5A illustrates a cross-sectional view across a substrate 401 having two adjacent semiconductor devices 502 and 504 that include many features described for semiconductor devices 402 and 404. Accordingly, semiconductor devices 502 and 504 are GAA structures that share a common source or drain region 406. Semiconductor device 502 includes semiconductor nanoribbons 506a while semiconductor device 504 includes semiconductor nanoribbons 506b.

Semiconductor nanoribbons 506a/506b include a gate dielectric 508 that may be similar to gate dielectric 114 described above. As discussed above, spacer structures 412 define the edges of semiconductor nanoribbons 506a/506b, according to some embodiments. The structure illustrated in Figure 5A may be similar to one or more GAA structures just before the formation of a gate electrode.

Figure 5B illustrates a cross-sectional view of the structure shown in Figure 5A following the selective removal of one or more nanoribbons, according to an embodiment of the present disclosure. Masking material 418, as discussed above, is deposited and patterned to cover one or more of the fins, such as the fin of semiconductor device 504 within the region between spacer structures 412. The top one or more suspended nanoribbons of any of the exposed devices (such as semiconductor device 502) may be removed using one or more anisotropic etches (such as a plasma-based etching process). In one example, a series of RIE processes are used to punch through any layers present on the top-most nanoribbon 506a before etching through the nanoribbon material itself. For example, a first RIE process may be used to punch through the top layer of gate dielectric 508 (different RIE processes may be used to punch through each layer of a multilayer gate dielectric). Once the semiconductor material of nanoribbon 506a is exposed, another RIE process may be used to etch away the exposed nanoribbon. This process may be repeated for however many nanoribbons are to be removed. In the illustrated embodiment, only a top nanoribbon 506a has been removed from semiconductor device 502. Note that gate dielectric 508 still remains around all lower nanoribbons beneath which nanoribbons have been removed. Additionally, in some embodiments, there is no gate dielectric 508 present on the sidewall of spacer structures 412 in the area where the removed one or more nanoribbons had been. In some other embodiments, another dielectric layer is deposited to effectively fill these discontinuities of gate dielectric layer 508 along the sidewalls of gate spacers 412.

Since the etching process used to remove one or more nanoribbons is performed after the formation of source or drain region 406, source or drain region 406 will extend above a top-most nanoribbon 506a of semiconductor device 502 at a first height *h₁* and extend above a top-most nanoribbon 506b of semiconductor device 504 at a second height *h₂* that is less than the first height *h₁*. The height difference will depend on the number of nanoribbons removed from semiconductor device 502. In some examples, height *h₁* may be between about 1 nm and about 5 nm and height *h₂* may be between about 10 nm and about 50 nm. Additionally, due to the timing of the etch process used to remove one or more nanoribbons, one or more dummy channel structures 420 are present within spacer structures 412 as already discussed above with reference to Figure 4C.

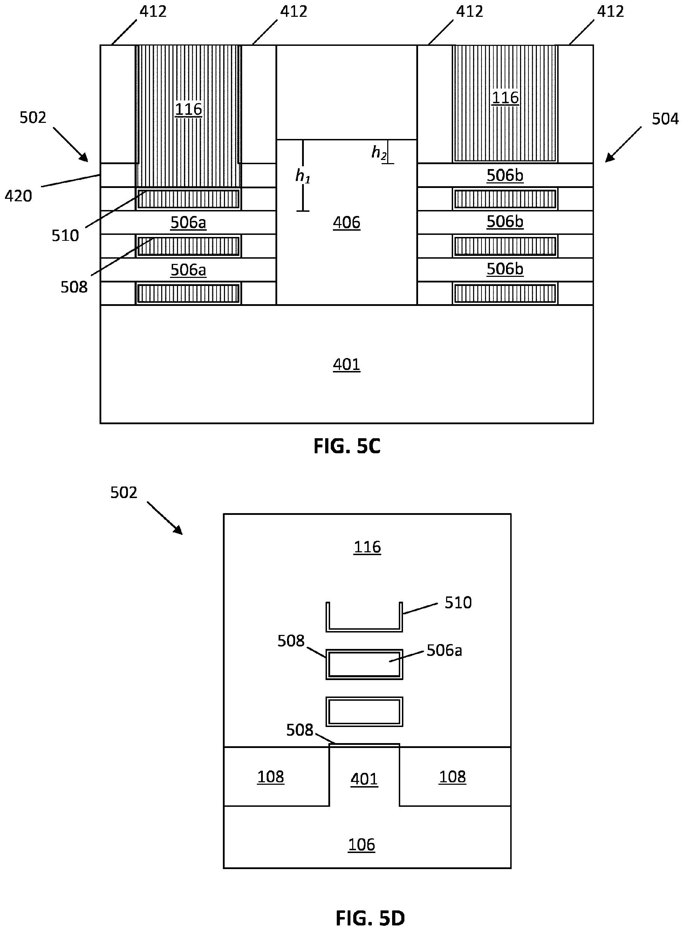

Figure 5C illustrates a cross-sectional view of the structure shown in Figure 5B following the formation of gate electrode 116, according to an embodiment of the present disclosure. Note that the dummy channel structures 420 remain in the final structure with one extending between source or drain region 406 and gate electrode 116 and the other extending between another source or drain region (not shown) and gate electrode 116.

In some embodiments, the timing of the nanoribbon removal after the formation of gate dielectric 508 may produce a dummy dielectric layer 510 suspended above the other nanoribbons 506a. Dummy dielectric layer 510 is from the dielectric gate 508 that had been surrounding the removed nanoribbon. Thus, according to some embodiments, dummy dielectric layer 510 extends between spacer structures 412 but does not surround or otherwise contact any of the semiconductor nanoribbons 506a. Figure 5D illustrates another cross-section view of semiconductor device 502 that is orthogonal to the cross-section view in Figure 5C passing through nanoribbons 506a. Dummy dielectric layer 510 may have a 'U' shape made up of the sides and bottom portion that had been around a nanoribbon (the top portion was removed during the removal of the nanoribbon). In some embodiments where the bottom portion of dummy dielectric layer 510 is removed (e.g., to remove further nanoribbons), only side portions of dummy dielectric layer 510 may remain extending between spacer structures 412.

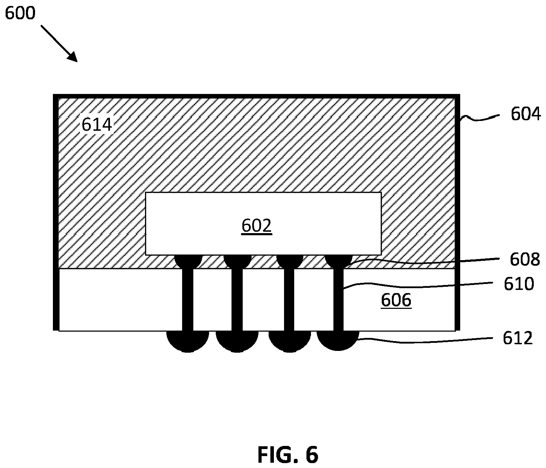

Figure 6 illustrates an example embodiment of a chip package 600, in accordance with an embodiment of the present disclosure. As can be seen, chip package 600 includes one or more dies 602. One or more dies 602 may include at least one integrated circuit having semiconductor devices, such as any of the semiconductor devices disclosed herein. One or more dies 602 may include any other circuitry used to interface with other devices formed on the dies, or other devices connected to chip package 600, in some example configurations.

As can be further seen, chip package 600 includes a housing 604 that is bonded to a package substrate 606. The housing 604 may be any standard or proprietary housing, and may provide, for example, electromagnetic shielding and environmental protection for the components of chip package 600. The one or more dies 602 may be conductively coupled to a package substrate 606 using connections 608, which may be implemented with any number of standard or proprietary connection mechanisms, such as solder bumps, ball grid array (BGA), pins, or wire bonds, to name a few examples. Package substrate 606 may be any standard or proprietary package substrate, but in some cases includes a dielectric material having conductive pathways (e.g., including conductive vias and lines) extending through the dielectric material between the faces of package substrate 606, or between different locations on each face. In some embodiments, package substrate 606 may have a thickness less than 1 millimeter (e.g., between 0.1 millimeters and 0.5 millimeters), although any number of package geometries can be used. Additional conductive contacts 612 may be disposed at an opposite face of package substrate 606 for conductively contacting, for instance, a printed circuit board (PCB). One or more vias 610 extend through a thickness of package substrate 606 to provide conductive pathways between one or more of connections 608 to one or more of contacts 612. Vias 610 are illustrated as single straight columns through package substrate 606 for ease of illustration, although other configurations can be used (e.g., damascene, dual damascene, through-silicon via, or an interconnect structure that meanders through the thickness of substrate 606 to contact one or more intermediate locations therein). In still other embodiments, vias 610 are fabricated by multiple smaller stacked vias, or are staggered at different locations across package substrate 606. In the illustrated embodiment, contacts 612 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 612, to inhibit shorting.

In some embodiments, a mold material 614 may be disposed around the one or more dies 602 included within housing 604 (e.g., between dies 602 and package substrate 606 as an underfill material, as well as between dies 602 and housing 604 as an overfill material). Although the dimensions and qualities of the mold material 614 can vary from one embodiment to the next, in some embodiments, a thickness of mold material 614 is less than 1 millimeter. Example materials that may be used for mold material 614 include epoxy mold materials, as suitable. In some cases, the mold material 614 is thermally conductive, in addition to being electrically insulating.

### Methodology

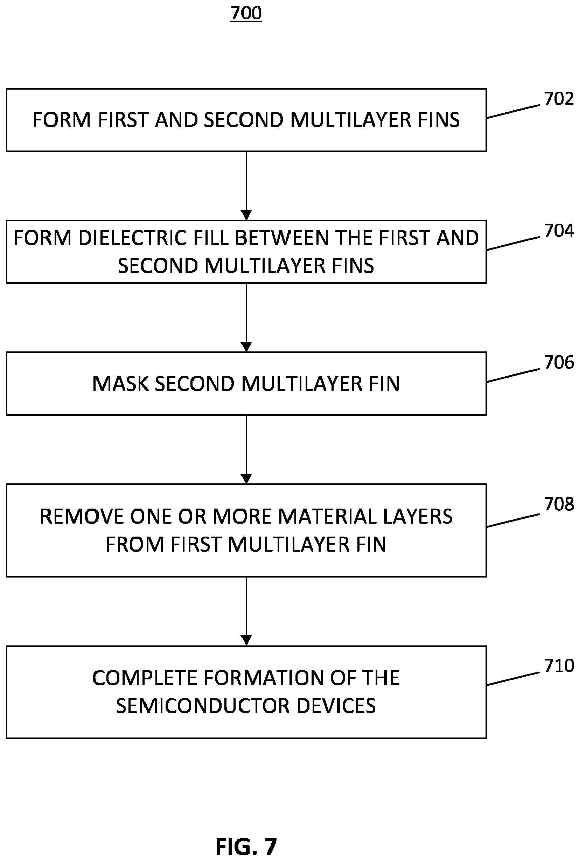

Figure 7 is a flow chart of a method 700 for forming at least a portion of an integrated circuit, according to an embodiment. Various operations of method 700 may be illustrated in Figures 2A-2F. However, the correlation of the various operations of method 700 to the specific components illustrated in the aforementioned figures is not intended to imply any structural and/or use limitations. Rather, the aforementioned figures provide one example embodiment of method 700. Other operations may be performed before, during, or after any of the operations of method 700. For example, method 700 does not explicitly describe many steps that are performed to form common transistor structures. Some of the operations of method 700 may be performed in a different order than the illustrated order.

Method 700 begins with operation 702 where at least first and second multilayer fins are formed. The multilayer fins may include alternating layers of sacrificial layers and semiconductor layers over a substrate. the thickness of each of the semiconductor layers and sacrificial layers may be between about 5 nm and about 25 nm. Each of the sacrificial layers and semiconductor layers may be deposited using any known material deposition technique, such as CVD, PECVD, PVD, or ALD. Once the material layers have been deposited, the fins may be defined via an anisotropic etching process, such as RIE, using a patterned mask material to protect the fins from the etch. The fin height may include the alternating material layers and a subfin portion formed from the substrate material. While dimensions can vary from one example embodiment to the next, the total height of the fins extending above the surface of the substrate may be in the range of about 100 nm to about 250 nm. The width of the fins can be, for example, in the range of about 5 to about 15 nm, such as 6 nm wide.

Method 700 continues with operation 704 where a dielectric fill is formed between at least the first and second fins. In some embodiments, the dielectric fill includes silicon oxide, although other oxides or dielectrics may be used as well. The dielectric fill may be deposited using any known dielectric material deposition technique, such as CVD, PECVD, flowable CVD, spin-on dielectric, or ALD, to name a few examples. The dielectric fill may first be deposited to at least fill the regions between adjacent fins, and then polished back until it is level with a top surface of the fins using, for example, CMP.

Method 700 continues with operation 706 where the second fin is masked using a masking layer, while exposing the first fin. The masking layer may be patterned to cover one or more n-channel semiconductor devices while exposing one or more of the p-channel semiconductor devices. Accordingly, in this example, the first fin may include semiconductor material with n-type dopants and the second fin may include semiconductor material with p-type dopants. The masking layer may be a photoresist or hard mask material, such as a carbon hard mask.

Method 700 continues with operation 708 where one or more material layers are removed from the exposed first fin. The top one or more material layers of the exposed fin may be removed using an isotropic or anisotropic etch process (such as a plasma-based etching process). In one example, RIE is used to remove any number of material layers from the exposed first fin. The removed material layers may include both semiconductor layers and sacrificial layers, or just a top-most semiconductor layer. Each semiconductor layer that is removed ultimately removes one nanoribbon from the resulting transistor of the first fin.

Method 700 continues with operation 710 where remaining transistor structures are formed to complete the formation of first and second semiconductor devices from the first and second fins, respectively. These remaining processes involve the formation of source and drain regions for each of the semiconductor devices, the removal of sacrificial material layers within each of the fins to form suspended semiconductor nanoribbons, the formation of a gate dielectric around the nanoribbons, and the formation of a gate electrode around the nanoribbons. The results of many of these processes are shown in Figures 3A and 3B, which include cross-section views of a first semiconductor device having a fewer number of nanoribbons than a second semiconductor device.

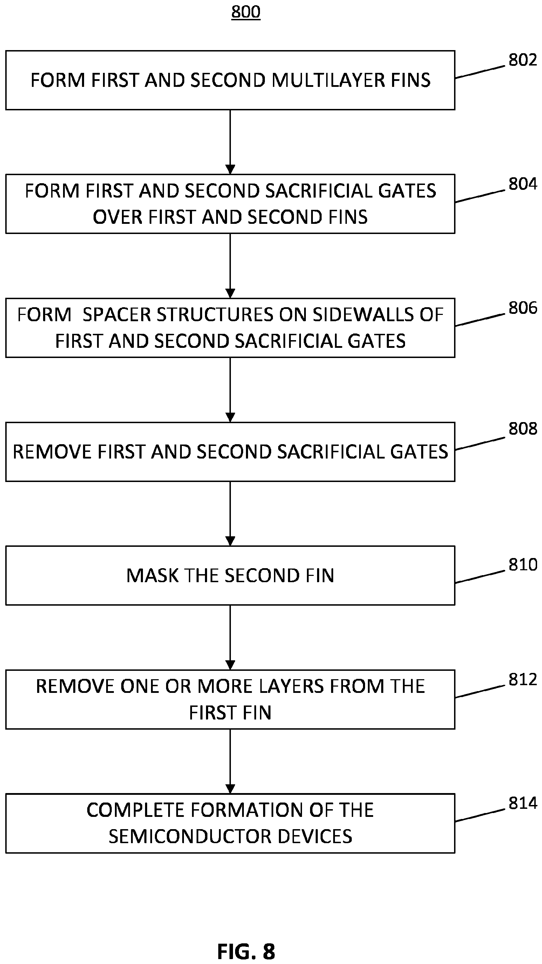

Figure 8 is a flow chart of a method 800 for forming at least a portion of an integrated circuit, according to an embodiment. Various operations of method 800 may be illustrated in Figures 4A - 4D. However, the correlation of the various operations of method 800 to the specific components illustrated in the aforementioned figures is not intended to imply any structural and/or use limitations. Rather, the aforementioned figures provide one example embodiment of method 800. Other operations may be performed before, during, or after any of the operations of method 800. For example, method 800 does not explicitly describe many steps that are performed to form common transistor structures. Some of the operations of method 800 may be performed in a different order than the illustrated order.

Method 800 begins with operation 802 where at least first and second multilayer fins are formed as described above for operation 702 of method 700.

Method 800 continues with operation 804 where first and second sacrificial gates are formed over the first and second fins. The sacrificial gates may run in an orthogonal direction to each of the fins and may include any material that can be safely removed later in the process without etching or otherwise damaging any portions of the fins or of the spacer structures formed in the next operation. In some embodiments, the sacrificial gates comprise polysilicon.

Method 800 continues with operation 806 where spacer structures are formed on the sidewalls of the sacrificial gates. The spacer structures may be formed using an etch-back process where spacer material is deposited everywhere and then anisotropically etched to leave the material only on sidewalls of structures. The spacer structures may include a dielectric material, such as silicon nitride, silicon oxy-nitride, or any formulation of those layers incorporating carbon or boron dopants. In some embodiments, source and drain regions would be formed on either ends of the first and second fins using any of the techniques described above, although the source and drain regions may also be formed later in method 800.

Method 800 continues with operation 808 where the sacrificial gates are removed. The sacrificial gates may be removed using any wet or dry isotropic process thus exposing the portions of the fins that had been under the sacrificial gates. The alternating layer stack of each of the fins would be exposed within the trench left behind between the spacer structures after the removal of the sacrificial gates.

Method 800 continues with operation 810 where the second fin is masked using a masking layer, while exposing the first fin. The masking layer may be patterned to cover one or more n-channel semiconductor devices while exposing one or more of the p-channel semiconductor devices. Accordingly, in this example, the first fin may include semiconductor material with n-type dopants and the second fin may include semiconductor material with p-type dopants. The masking layer may be a photoresist or hard mask material, such as a carbon hard mask.

Method 800 continues with operation 812 where one or more material layers are removed from the exposed first fin. The top one or more material layers of the exposed fin may be removed using an isotropic or anisotropic etch process (such as a plasma-based etching process). In one example, RIE is used to remove any number of material layers from the exposed first fin. The removed material layers may include both semiconductor layers and sacrificial layers, or just a top-most semiconductor layer. Each semiconductor layer that is removed ultimately removes one nanoribbon from the resulting transistor of the first fin.

Method 800 continues with operation 814 where remaining transistor structures are formed to complete the formation of first and second semiconductor devices from the first and second fins, respectively. These remaining processes involve the removal of sacrificial material layers within each of the fins to form suspended semiconductor nanoribbons, the formation of a gate dielectric around the nanoribbons, and the formation of a gate electrode around the nanoribbons. The results of many of these processes are shown in Figure 4D, which include cross-section views of a first semiconductor device having a fewer number of nanoribbons than a second adjacent semiconductor device.

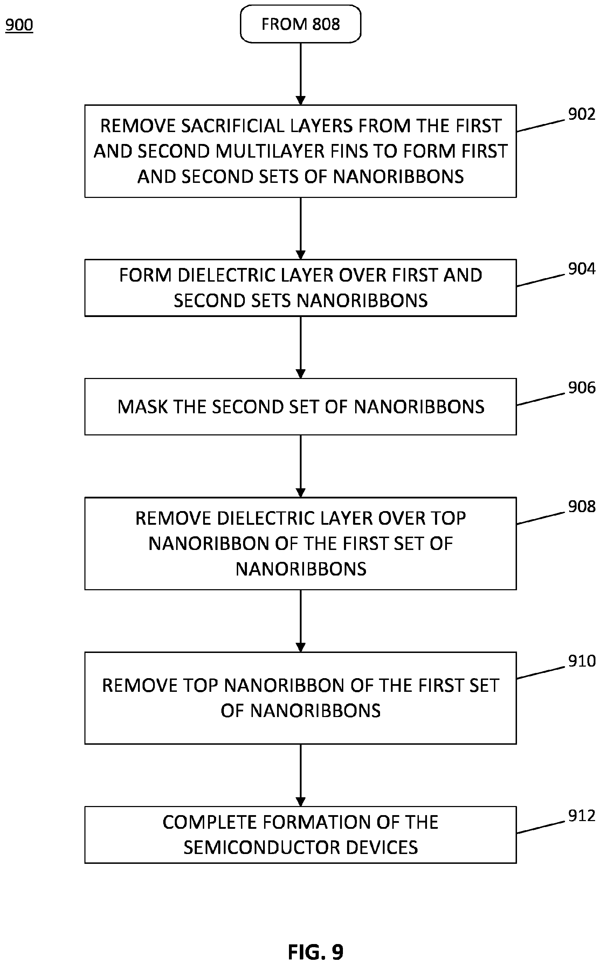

Figure 9 is a flow chart of a method 900 for forming at least a portion of an integrated circuit, according to an embodiment. Various operations of method 900 may be illustrated in Figures 5A - 5D. However, the correlation of the various operations of method 900 to the specific components illustrated in the aforementioned figures is not intended to imply any structural and/or use limitations. Rather, the aforementioned figures provide one example embodiment of method 900. Other operations may be performed before, during, or after any of the operations of method 900. For example, method 900 does not explicitly describe many steps that are performed to form common transistor structures. Some of the operations of method 900 may be performed in a different order than the illustrated order.

Method 900 begins with operation 902, which may occur after operations 802 - 808 from method 800 have been performed. Thus, the structure includes first and second multilayer fins extending between source and drain regions along with spacer structures over the ends of the fins. At operation 902, the sacrificial layers are removed from each of the first and second fins to form a suspended first set of nanoribbons from the first fin and a suspended second set of nanoribbons from the second fin. The sacrificial layers may be removed using a selective isotropic etching process that removes the material of the sacrificial layers but does not remove (or removes very little of) the semiconductor layers.

Method 900 continues with operation 904 where a gate dielectric is formed over the first and second sets of nanoribbons. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on the nanoribbons, and a second layer on the first layer. The first layer can be, for instance, an oxide of the nanoribbon material (e.g., silicon dioxide) and the second layer can be a high-k dielectric material (e.g., hafnium oxide).

Method 900 continues with operation 906 where the second set of nanoribbons are masked using a masking layer, while exposing the first set of nanoribbons. The masking layer may be patterned to cover one or more n-channel semiconductor devices while exposing one or more of the p-channel semiconductor devices. Accordingly, in this example, the first set of nanoribbons may include semiconductor material with n-type dopants and the second set of nanoribbons may include semiconductor material with p-type dopants. The masking layer may be a photoresist or hard mask material, such as a carbon hard mask.

Method 900 continues with operation 908 where the gate dielectric over the top nanoribbon of the first set of nanoribbons is removed. The gate dielectric may be removed using any anisotropic etching process, such as an RIE process to etch through the dielectric material.

Method 900 continues with operation 910 where the top nanoribbon of the first set of nanoribbons is removed. According to some embodiment, the semiconductor material of the top nanoribbon may be removed using any anisotropic etching process. In one example, the same RIE processed used to etch through the gate dielectric in operation 908 is used continuously to also etch through the semiconductor material of the top nanoribbon of the first set of nanoribbons. In another example, a first RIE process is used to etch through the gate dielectric and a second different RIE process is used to etch through the semiconductor material of the top nanoribbon of the first set of nanoribbons. It should be understood that operations 908 and 910 may be repeated any number of times to remove any number of nanoribbons from the first set of nanoribbons.

Method 900 continues with operation 912 where remaining transistor structures are formed to complete the formation of first and second semiconductor devices from the first and second fins, respectively. The remaining one or more processes involve at least the formation of a gate electrode around the nanoribbons. The results of these one or more processes are shown in Figures 5C and 5D, which include cross-section views of a first semiconductor device having a fewer number of nanoribbons than a second adjacent semiconductor device. Additionally, the first semiconductor device includes one or more dummy dielectric layers (depending on how many nanoribbons were removed) suspended above the remaining nanoribbons of the first semiconductor device, according to some embodiments.

### Example System

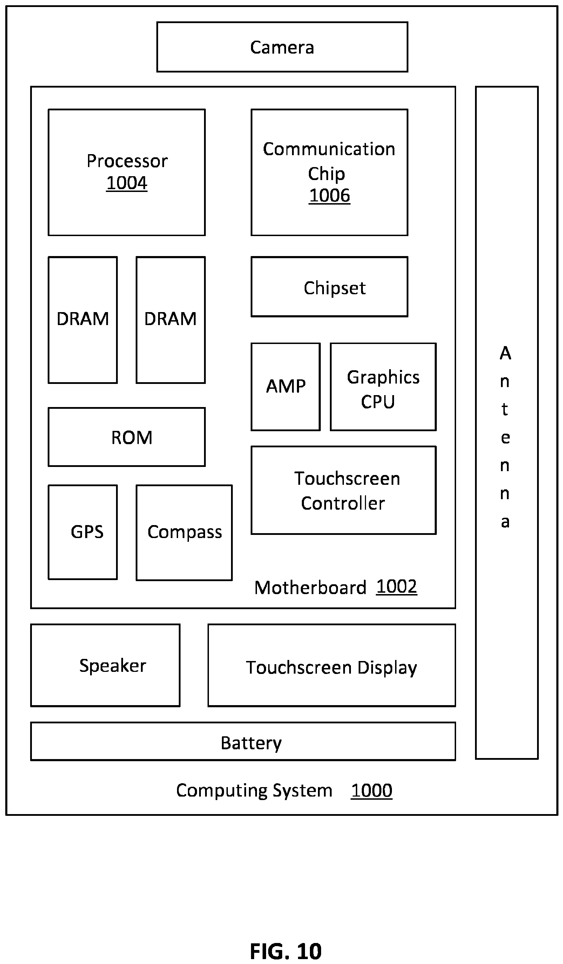

FIG. 10 is an example computing system implemented with one or more of the integrated circuit structures as disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board (PCB), whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices configured in accordance with an example embodiment (e.g., a module including an integrated circuit device on a substrate, the substrate having one or more first semiconductor devices with a first number of nanoribbons and one or more second semiconductor devices with a second number of nanoribbons different from the first number, as variously provided herein). In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more semiconductor devices as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1000 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first set of two or more semiconductor nanoribbons extending between a first source region and a first drain region, and a second semiconductor device having a second set of one or more semiconductor nanoribbons extending between a second source region and a second drain region. The second set of semiconductor nanoribbons has a fewer number of nanoribbons than the first set of semiconductor nanoribbons.

Example 2 includes the subject matter of Example 1, wherein a first height between a bottommost nanoribbon and a topmost nanoribbon of the first set of semiconductor nanoribbons is greater than a second height between a bottommost nanoribbon and a topmost nanoribbon of the second set of semiconductor nanoribbons.

Example 3 includes the subject matter of Example 1 or 2, wherein a spacing between adjacent nanoribbons of the first set of semiconductor nanoribbons is substantially the same as a spacing between adjacent nanoribbons of the second set of semiconductor nanoribbons.

Example 4 includes the subject matter of any one of Examples 1-3, wherein the first semiconductor device is an n-channel device and the second semiconductor device is a p-channel device.

Example 5 includes the subject matter of any one of Examples 1-4, wherein the first source region and the first drain region extend above a topmost nanoribbon of the first set of semiconductor nanoribbons by a first height, and the second source region and the second drain region extend above a topmost nanoribbon of the second set of semiconductor nanoribbons by a second height that is greater than the first height.

Example 6 includes the subject matter of Example 5, wherein the first drain region and the second drain region are the same region.

Example 7 includes the subject matter of any one of Examples 1-6, wherein the second semiconductor device comprises a gate electrode around the second set of semiconductor nanoribbons and a spacer along a side of the gate electrode, wherein the spacer includes a dummy channel structure that extends between the second drain region and the gate electrode or between the second source region and the gate electrode.

Example 8 includes the subject matter of any one of Examples 1-7, wherein the second semiconductor device comprises a dielectric layer around each of the second set of semiconductor nanoribbons and a dummy dielectric layer suspended above the second set of semiconductor nanoribbons, where the dummy dielectric layer is not on any semiconductor nanoribbon.

Example 9 includes the subject matter of any one of Examples 1-8, wherein the first set of semiconductor nanoribbons and the second set of semiconductor nanoribbons comprise germanium, silicon, or a combination thereof.

Example 10 is a printed circuit board comprising the integrated circuit of any one of Examples 1-9.

Example 11 is an integrated circuit that includes a first semiconductor device having a first set of two or more semiconductor bodies extending between a first source region and a first drain region, and a second semiconductor device having a second set of one or more semiconductor bodies extending between a second source region and a second drain region. The first semiconductor device has a first gate structure wrapped around the first set of two or more semiconductor bodies and the second semiconductor device has a second gate structure wrapped around the second set of one or more semiconductor bodies. The second set of semiconductor bodies has a fewer number of semiconductor bodies than the first set of semiconductor bodies.

Example 12 is an electronic device that includes a chip package comprising one or more dies. At least one of the one or more dies includes a first semiconductor device having a first set of two or more semiconductor nanoribbons extending between a first source region and a first drain region, and a second semiconductor device having a second set of one or more semiconductor nanoribbons extending between a second source region and a second drain region. The second set of semiconductor nanoribbons has a fewer number of nanoribbons than the first set of semiconductor nanoribbons.

Example 13 includes the subject matter of Example 12, wherein a first height between a bottommost nanoribbon and a topmost nanoribbon of the first plurality of semiconductor nanoribbons is greater than a second height between a bottommost nanoribbon and a topmost nanoribbon of the second plurality of semiconductor nanoribbons.

Example 14 includes the subject matter of Examples 12 or 13, wherein a spacing between adjacent nanoribbons of the first plurality of semiconductor nanoribbons is substantially the same as a spacing between adjacent nanoribbons of the second plurality of semiconductor nanoribbons.

Example 15 includes the subject matter of any one of Examples 12-14, wherein the first semiconductor device is an n-channel device and the second semiconductor device is a p-channel device.

Example 16 includes the subject matter of any one of Examples 12-15, wherein the first source region and the first drain region extend above a topmost nanoribbon of the first plurality of semiconductor nanoribbons by a first height, and the second source region and the second drain region extend above a topmost nanoribbon of the second plurality of semiconductor nanoribbons by a second height that is greater than the first height.

Example 17 includes the subject matter of Example 16, wherein the first drain region and the second drain region are the same region.

Example 18 includes the subject matter of any one of Examples 12-17, wherein the second semiconductor device comprises a gate electrode around the second plurality of semiconductor nanoribbons and a spacer along a side of the gate electrode, wherein the spacer includes a dummy channel structure that extends between the second drain region and the gate electrode or between the second source region and the gate electrode.

Example 19 includes the subject matter of any one of Examples 12-18, wherein the second semiconductor device comprises a dielectric layer around each of the second plurality of semiconductor nanoribbons and a dummy dielectric layer suspended above the second plurality of semiconductor nanoribbons, where the dummy dielectric layer is not on any nanoribbon.

Example 20 includes the subject matter of any one of Examples 12-19, wherein the first plurality of semiconductor nanoribbons and the second plurality of semiconductor nanoribbons comprise germanium, silicon, or an alloy thereof.

Example 21 is a method of forming an integrated circuit. The method includes forming a first multilayer fin and a second multilayer fin, each of the first and second multilayer fins comprising first and second material layers, wherein the second material layers comprise a semiconductor material suitable for use as a nanoribbon; forming a dielectric layer between the first multilayer fin and the second multilayer fin; masking the second multilayer fin while leaving the first multilayer fin exposed; and removing at least a topmost second material layer from the first multilayer fin.

Example 22 includes the subject matter of Example 21, wherein removing at least the topmost second material layer comprises using an anisotropic etching procedure to remove the at least the topmost second material layer.

Example 23 includes the subject matter of Example 21 or 22, further comprising: removing a topmost first material layer from the first multilayer fin; and removing another second material layer from the first multilayer fin.

Example 24 includes the subject matter of any one of Examples 21-23, further comprising: forming a first drain region and a first source region on opposite sides of the first multilayer fin; and forming a second drain region and a second source region on opposite sides of the second multilayer fin, wherein a first height of the first drain region and the first source region is less than a second height of the second drain region and the second source region.

Example 25 includes the subject matter of any one of Examples 21-24, wherein the masking comprises forming a carbon hard mask over the second multilayer fin.

Example 26 includes the subject matter of any one of Examples 21-25, further comprising doping the second material layers of the first multilayer fin with p-type dopants and doping the second material layers of the second multilayer fin with n-type dopants.

Example 27 includes the subject matter of any one of Examples 21-26, further comprising removing the first material layers from the first multilayer fin and the first material layers from the second multilayer fin.

Example 28 is a method of forming an integrated circuit. The method includes forming a first multilayer fin and a second multilayer fin, each of the first and second multilayer fins comprising first and second material layers, wherein the second material layers comprise a semiconductor material suitable for use as a nanoribbon; forming a first sacrificial gate structure over the first multilayer fin and a second sacrificial gate structure over the second multilayer fin; forming a first gate structure spacer on sidewalls of the first sacrificial gate structure and a second gate structure spacer on sidewalls of the second sacrificial gate structure; removing the first sacrificial gate structure and the second sacrificial gate structure; and removing at least a topmost second material layer from the first multilayer fin while protecting a topmost second material layer from the second multilayer fin.

Example 29 includes the subject matter of Example 28, further comprising masking the second multilayer fin while leaving the first multilayer fin exposed.

Example 30 includes the subject matter of Example 29, wherein the masking comprises forming a carbon hard mask within a trench left behind by the removal of the second sacrificial gate structure.

Example 31 includes the subject matter of any one of Examples 28-30, further comprising: removing the first material layers from the first multilayer fin and the first material layers from the second multilayer fin to form a first plurality of nanoribbons comprising the second material layers of the first multilayer fin and a second plurality of nanoribbons comprising the second material layers of the second multilayer fin, respectively; depositing a dielectric layer around the second material layers of the first plurality of nanoribbons and the second material layers of the second plurality of nanoribbons; and removing a portion of the dielectric layer around the topmost second material layer of the first plurality of nanoribbons.

Example 32 includes the subject matter of any one of Examples 28-31, further comprising forming a source or drain region between the first multilayer fin and the second multilayer fin, wherein, following the removing of at least the topmost second material layer from the first multilayer fin, the source or drain region extends above a next topmost second material layer from the first multilayer fin by a first height, and the source or drain region extends above the topmost second material layer of the second multilayer fin by a second height that is less than the first height.

Example 33 includes the subject matter of any one of Examples 28-32, further comprising doping the second material layers of the first multilayer fin with p-type dopants and doping the second material layers of the second multilayer fin with n-type dopants.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first set of two or more semiconductor nanoribbons extending between a first source region and a first drain region; and
a second semiconductor device having a second set of one or more semiconductor nanoribbons extending between a second source region and a second drain region, the second set of semiconductor nanoribbons having a fewer number of nanoribbons than the first set of semiconductor nanoribbons.

2. The integrated circuit of claim 1, wherein a first height between a bottommost nanoribbon and a topmost nanoribbon of the first set of semiconductor nanoribbons is greater than a second height between a bottommost nanoribbon and a topmost nanoribbon of the second set of semiconductor nanoribbons.

3. The integrated circuit of claim 1 or 2, wherein a spacing between adjacent nanoribbons of the first set of semiconductor nanoribbons is substantially the same as a spacing between adjacent nanoribbons of the second set of semiconductor nanoribbons.

4. The integrated circuit of any one of claims 1 through 3, wherein the first semiconductor device is an n-channel device and the second semiconductor device is a p-channel device.

5. The integrated circuit of any one of claims 1 through 4, wherein the first source region and the first drain region extend above a topmost nanoribbon of the first set of semiconductor nanoribbons by a first height, and the second source region and the second drain region extend above a topmost nanoribbon of the second set of semiconductor nanoribbons by a second height that is greater than the first height.

6. The integrated circuit of claim 5, wherein the first drain region and the second drain region are the same region.

7. The integrated circuit of any one of claims 1 through 6, wherein the second semiconductor device comprises a gate electrode around the second set of semiconductor nanoribbons and a spacer along a side of the gate electrode, wherein the spacer includes a dummy channel structure that extends between the second drain region and the gate electrode or between the second source region and the gate electrode.

8. The integrated circuit of any one of claims 1 through 7, wherein the second semiconductor device comprises a dielectric layer around each of the second set of semiconductor nanoribbons and a dummy dielectric layer suspended above the second set of semiconductor nanoribbons, where the dummy dielectric layer is not on any semiconductor nanoribbon.

9. The integrated circuit of any one of claims 1 through 8, wherein the first set of semiconductor nanoribbons and the second set of semiconductor nanoribbons comprise germanium, silicon, or a combination thereof.

10. A printed circuit board comprising the integrated circuit of any one of claims 1 through 9.

11. A method of forming an integrated circuit, comprising:
forming a first multilayer fin and a second multilayer fin, each of the first and second multilayer fins comprising first and second material layers, wherein the second material layers comprise a semiconductor material suitable for use as a nanoribbon;
forming a dielectric layer between the first multilayer fin and the second multilayer fin;
masking the second multilayer fin while leaving the first multilayer fin exposed; and
removing at least a topmost second material layer from the first multilayer fin.

12. The method of claim 11, further comprising:
removing a topmost first material layer from the first multilayer fin; and
removing another second material layer from the first multilayer fin.

13. The method of claim 11 or 12, further comprising:
forming a first drain region and a first source region on opposite sides of the first multilayer fin; and
forming a second drain region and a second source region on opposite sides of the second multilayer fin, wherein a first height of the first drain region and the first source region is less than a second height of the second drain region and the second source region.

14. The method of any one of claims 11 through 13, further comprising doping the second material layers of the first multilayer fin with p-type dopants and doping the second material layers of the second multilayer fin with n-type dopants.

15. The method of any one of claims 11 through 14, further comprising removing the first material layers from the first multilayer fin and the first material layers from the second multilayer fin.
